Europäisches Patentamt

European Patent Office

Office européen des brevets

(19)

(11) Numéro de publication : **0 070 064
B1**

(12) **FASCICULE DE BREVET EUROPÉEN**

(45) Date de publication du fascicule du brevet :
09.10.85

(51) Int. Cl.⁴ : **H 01 L 27/01, H 01 G 4/10**

(21) Numéro de dépôt : **82200814.0**

(22) Date de dépôt : **30.06.82**

(54) Procédé destiné à accroître la tension de claquage d'un condensateur intégré et condensateur ainsi réalisé.

(30) Priorité : 08.07.81 FR 8113424

(43) Date de publication de la demande :
19.01.83 Bulletin 83/03

(45) Mention de la délivrance du brevet :
09.10.85 Bulletin 85/41

(84) Etats contractants désignés :
DE FR GB NL

(56) Documents cités :
FR-A- 2 138 339
US-A- 3 432 918
US-A- 3 714 529
29th ELECTRONIC COMPONENTS CONFERENCE,
14-16 mai 1979, pages 126-131, Cherry Hill, The
Institute of Electrical and Electronics Engineers, Inc.,
New York (USA); M. CAULTON: "Substrates, materials and processes for microwave applications"

(73) Titulaire : **Laboratoires d'Electronique et de Physique
Appliquée L.E.P.
3, Avenue Descartes
F-94450 Limeil-Brévannes (FR)
FR
N.V. Philips' Gloeilampenfabrieken
Groenewoudseweg 1
NL-5621 BA Eindhoven (NL)
DE GB NL**

(72) Inventeur : **Binet, Michel Joseph Marie
Société Civile S.P.I.D. 209, rue de l'Université
F-75007 Paris (FR)**

(74) Mandataire : **Gendraud, Pierre et al
Société Civile S.P.I.D. 209, rue de l'Université
F-75007 Paris (FR)**

## Description

L'invention concerne un procédé destiné à accroître la tension de claquage d'un condensateur, réalisé de façon intégrée sur un substrat semi-conducteur, et comprenant une première couche métallique déposée sur au moins une partie du substrat semi-conducteur, une couche diélectrique déposée sur ou réalisée à partir de ladite première couche métallique, et une seconde couche métallique recouvrant ladite seconde couche diélectrique, et s'étendant sur au moins une autre partie du substrat semi-conducteur. Elle s'étend aux condensateurs intégrés ainsi réalisés.

Les condensateurs intégrés sont bien connus de l'art antérieur, et sont réalisés notamment sous la forme d'un empilement de couches minces, du type conducteur-diélectrique-conducteur.

En vue de la réalisation de condensateur à forte capacité, il est nécessaire de déposer une très fine couche de diélectrique (inférieure à 100 mm), entre deux couches métalliques formant les armatures dudit condensateur et de nombreux problèmes surviennent alors, notamment la difficulté de contrôler l'épaisseur de la couche diélectrique, ainsi que la chute de la tension de claquage, phénomène qui se produit plus particulièrement au voisinage des bords.

L'invention vise à pallier les susdits inconvénients en proposant un nouveau procédé de réalisation de ces condensateurs.

Le procédé selon l'invention est remarquable en ce que l'on dépose une première couche métallique sur au moins une partie d'un substrat semi-conducteur, l'on enlève une partie du substrat semi-conducteur en bordure de et sous ladite première couche métallique, puis en ce que l'on dépose ou réalise ladite couche diélectrique de manière à ce qu'elle recouvre totalement la surface libre de ladite première couche métallique et enfin en ce que l'on dépose la seconde couche métallique, de manière à recouvrir ladite seconde couche diélectrique et à s'étendre sur au moins une autre partie du substrat semi-conducteur, alors qu'on laisse un espace vide en bordure de et sous ladite première couche métallique recouverte de la couche diélectrique.

De cette manière, les deux couches métalliques sont éloignées, au voisinage du bord, d'une distance suffisante pour diminuer dans une large mesure les phénomènes de claquage.

Le matériau semi-conducteur peut être en silicium, en un composé III-V... et selon une variante de réalisation, il est en arséniure de gallium, composé qui est largement utilisé dans la réalisation de composants hyperfréquences, du fait de ses très bonnes qualités intrinsèques.

Selon une réalisation de l'invention, la première couche métallique est en aluminium, alors que la seconde couche diélectrique est de l'alumine réalisée par anodisation superficielle de cette première couche métallique.

La description qui va suivre, en regard des dessins annexés donnés à titre non limitatif, permettra de mieux comprendre l'invention et d'en apprécier sa portée.

La figure 1 est une coupe d'un condensateur intégré selon l'art antérieur.

Les figures 2 à 5 sont des vues en coupe des différentes étapes du procédé selon la présente invention.

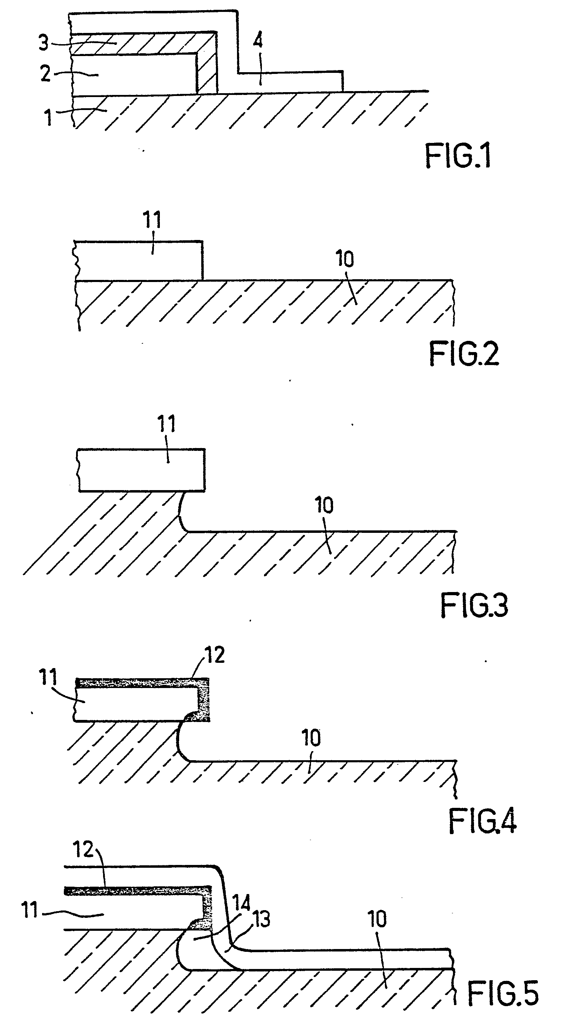

Selon l'art antérieur, un condensateur intégré tel que représenté à la figure 1, comprend sur un substrat semi-conducteur 1, une première couche métallique 2, par exemple en tantale, en aluminium..., une couche diélectrique 3, par exemple de la silice $SiO_2$ obtenue par dépôt par vapeur chimique (en anglais CVD, pour « chemical vapor deposition ») ou du nitrure de silicium $Si_3N4$, obtenu par dépôt par plasma à basse température, et enfin une seconde couche métallique 4 qui s'étend sur ces précédentes couches et déborde sur le substrat semi-conducteur 1, de façon à ménager une aire suffisante pour la prise de contact.

Lorsque la couche diélectrique 3 est très fine par exemple d'une épaisseur inférieure à 1 000 Å, à la bordure de ladite première couche métallique, il se produit fréquemment des phénomènes de claquage pour des tensions de l'ordre de quelques volts, dus à la faible distance entre les deux armatures métalliques, au travers du substrat semi-conducteur.

Une solution à ce problème consiste à étendre la couche diélectrique 3, de façon à ce qu'elle déborde également sur le substrat semi-conducteur 1. Mais, cette solution n'est pas toujours envisageable, notamment lorsque la couche diélectrique n'est pas une couche déposée, mais une couche réalisée à partir de la première couche, par exemple par oxydation superficielle.

Le procédé de réalisation de condensateurs intégrés, selon la présente invention consiste en la succession des étapes suivantes, illustrées par les figures 2 à 5 :

Dans une première étape, telle que représentée à la figure 2, on dépose sur un substrat semi-conducteur 10, une première couche métallique 11, par exemple de l'aluminium (ou du tantale ...), selon un procédé classique, tel que l'évaporation sous vide, au travers d'un masque, ou par sérigraphie d'une pâte à l'aluminium, ou tout autre procédé approprié.

Dans une seconde étape, telle que représentée à la figure 3, les mêmes éléments portant les mêmes références, on enlève une partie du substrat semi-conducteur 10, par exemple au moyen d'un bain d'attaque chimique, et l'on poursuit cette attaque sous la première couche métallique de façon à réaliser une sous-gravure sur une distance de l'ordre du micron. Dans le cas d'un matériau semi-conducteur, tel que le GaAs, un bain d'attaque chimique tel que l'acide citrique dilué (et additionné d'eau oxygénée) convient parfaitement ; une sous-gravure de 1 μm est

obtenue en une dizaine de minutes, et l'on arrête cette attaque en trempant plusieurs fois le substrat dans de l'eau désionisée.

Dans une troisième étape, telle que représentée à la figure 4 on dépose sur ou on réalise à partir de la première couche métallique 11, une seconde couche diélectrique 12, de manière à ce qu'elle recouvre totalement la surface libre de ladite première couche métallique 11 sur trois côtés.

De façon préférentielle, ce recouvrement total est obtenu par anodisation superficielle de ladite première couche métallique 11. Ainsi, dans le cas d'une première couche en aluminium, celle-ci se transforme superficiellement en alumine, par anodisation par voie humide, selon un procédé bien connu, qui consiste à immerger ladite couche à recouvrir dans un électrolyte (eau + acide tartrique, par exemple), et à faire circuler un courant entre une électrode de platine, faisant office de cathode, et ladite couche d'aluminium, faisant office d'anode. En quelques minutes, suivant la densité du courant, on peut obtenir une couche d'alumine de plusieurs centaines d'Ängstroms, et l'application d'une différence de potentiel constante, pendant quelques dizaines de minutes permet de densifier cette couche, de façon à la rendre plus conforme, en vue de l'utilisation projetée.

Dans une quatrième et dernière étape, telle que représentée à la figure 5, on dépose une seconde couche métallique 13, de telle manière qu'elle recouvre ladite seconde couche diélectrique 12, et qu'elle s'étende sur une autre partie du substrat semi-conducteur, de manière à réaliser une aire de contact, ou à assurer l'interconnexion avec d'autres éléments réalisés sur le substrat semi-conducteur 10, ou en relation avec.

Cette seconde couche métallique 13 peut être indifféremment en toute sorte de matériau bon conducteur de l'électricité, tel que le titane, l'or ...

Le dépôt de cette couche peut avoir lieu par tous moyens tels que l'évaporation sous vide, la sérigraphie, la pulvérisation réactive..., moyens propres à assurer la permanence d'un coin d'air, non recouvert 14 ; un tel coin d'air 14 permet d'assurer un écartement convenable entre les deux couches métalliques 12 et 13, formant les armatures du condensateur, de telle sorte que le trajet électrique au travers du substrat semiconducteur soit suffisamment important pour que la tension de claquage s'élève à des valeurs convenables, supérieures à 10 volts, eu égard aux capacités obtenues, de l'ordre de 2 000 pf/mm². 

En outre, les mesures hyperfréquences menées par la Demanderesse, sur les condensateurs ainsi réalisés, ont mis en évidence une très faible variation de la capacité avec la fréquence, jusqu'à des valeurs aussi élevées que 12 GHz, alors que les pertes étaient largement inférieures à 0.1 dB.

## Revendications

1. Procédé destiné à accroître la tension de claquage d'un condensateur, réalisé de façon intégrée sur un substrat semi-conducteur, et comprenant une première couche métallique déposée sur au moins une partie du substrat semi-conducteur, une couche diélectrique déposée sur ou réalisée à partir de ladite première couche métallique, et une seconde couche métallique recouvrant ladite couche diélectrique, et s'étendant sur au moins une autre partie du substrat semi-conducteur caractérisé en ce que l'on dépose une première couche métallique (11) sur au moins une partie d'un substrat semi-conducteur (10), l'on enlève une partie du substrat semi-conducteur en bordure de et sous ladite première couche métallique, puis en ce que l'on dépose ou réalise ladite couche diélectrique (12) de manière à ce qu'elle recouvre totalement la surface libre de ladite première couche métallique et enfin en ce que l'on dépose la seconde couche métallique (13), de manière à recouvrir ladite couche diélectrique et à s'étendre sur au moins une autre partie du substrat semi-conducteur, alors qu'on laisse un espace vide (14) en bordure de et sous ladite première couche métallique recouverte de la couche diélectrique.

2. Procédé selon la revendication 1, caractérisé en ce que le substrat semi-conducteur est en arséniure de gallium.

3. Procédé selon la revendication 1 ou 2, caractérisé en ce que ladite première couche métallique est en aluminium.

4. Procédé selon la revendication 3, caractérisé en ce que ladite seconde couche diélectrique est de l'alumine, réalisée par anodisation superficielle de ladite première couche métallique en aluminium.

5. Procédé selon l'une des revendications 1 à 4, caractérisé en ce que l'on enlève une partie du substrat semi-conducteur, en bordure de et sous ladite première couche métallique, au moyen d'un bain d'attaque chimique.

6. Procédé selon les revendications 2 et 5, caractérisé en ce que le bain d'attaque chimique est de l'acide citrique.

## Claims

1. A method intended to increase the breakdown voltage of a capacitor realized in integrated form on a semiconductor substrate and comprising a first metallic layer deposited on at least a part of the semiconductor substrate, a dielectric layer deposited on or formed from the said metallic layer and a second metallic layer covering the said dielectric layer and extending over at least another part of the semi-conductor substrate, characterized in that a first metallic layer (11) is deposited on at least a part of a semiconductor substrate (10), in that a part of the semiconductor substrate along the periphery of and under the said first metallic layer is removed, in that then the said dielectric layer (12) is deposited or formed in such a manner that it covers entirely the free surface of the said first metallic layer, and finally in that the second metallic layer (13) is deposited in such a manner that it covers the said dielectric layer and extends over at least another part of the semiconductor substrate, while a space (14) is left empty along the periphery of and under the said first metallic layer covered by the dielectric layer.

2. A method as claimed in Claim 1, characterized in that the semiconductor substrate consists of gallium arsenide.

3. A method as claimed in Claim 1 or 2, characterized in that the said first metallic layer consists of aluminium.

4. A method as claimed in Claim 3, characterized in that the said second dielectric layer consists of alumina obtained by superficial anodization of the said first metallic layer of aluminium.

5. A method as claimed in any one of Claims 1 to 4 inclusive, characterized in that a part of the semiconductor substrate is removed along the periphery of and under the said first metallic layer by means of a chemical etching bath.

6. A method as claimed in Claims 2 and 5, characterized in that the chemical etching bath comprises citric acid.

**Patentansprüche**

1. Verfahren zum Erhöhen der Durchbruchspannung eines Kondensators, der auf einem Substrat eines Halbleiterkörpers integriert ist mit einer ersten Metallschicht, die auf wenigstens einem Teil des Halbleitersubstrates niedergeschlagen ist, einer dielektrischen Schicht, die auf der ersten Metallschicht nidergeschlagen ist oder aus dieser Schicht gebildet ist und mit einer zweiten Metallschicht, welche die dielektrische Schicht bedeckt und sich über wenigstens einen anderen Teil des Halbleitersubstrates erstreckt, dadurch gekennzeichnet, dass auf wenigstens einem Teil des Halbleitersubstrates (10) eine erste Metallschicht (11) niedergeschalgen wird, dass danach ein Teil des Halbleitersubstrates am Rande von und unter der ersten Metallschicht entfernt wird, dass dann die dielektrische Schicht (12) niedergeschlagen oder gebildet wird, so dass diese die freie Oberfläche der ersten Metallschicht völlig bedeckt und dass zum Schluss die zweite Metallschicht (13) niedergeschlagen wird, so dass die dielektrische Schicht bedeckt und sich über wenigstens einen anderen Teil des Halbleitersubstrates erstreckt, während ein leerer Raum (14) an dem Rand von und unter der ersten Metallschicht, die mit der dielektrischen Schicht bedeckt ist, freigelassen wird.

2. Verfahren nach Anspruch 1, dadurch gekennzeichnet, dass das Halbleitersubstrat aus Galliumarsenid besteht.

3. Verfahren nach Anspruch 1 oder 2, dadurch gekennzeichnet, dass die erste Metallschicht aus Aluminium besteht.

4. Verfahren nach Anspruch 3, dadurch gekennzeichnet, dass die zweite dielektrische Schicht aus Aluminiumoxid besteht, das durch oberflächliche Anodisierung der ersten Metallschicht aus Aluminium erhalten worden ist.

5. Verfahren nach einem der Ansprüche 1 bis 4, dadurch gekennzeichnet, dass ein Teil des Halbleitersubstrates an dem Umfang von und unter der ersten Metallschicht mittels eines chemischen Ätzbades entfernt wird.

6. Verfahren nach Anspruch 2 und 5, dadurch gekennzeichnet, dass das chemische Ätzbad Zitronensäure enthält.

0 070 064

FIG.1

FIG.2

FIG.3

FIG.4

FIG.5